(19) Europäisches Patentamt / European Patent Office / Office européen des brevets

(11) **EP 2 653 307 A1**

(12) **EUROPEAN PATENT APPLICATION**
published in accordance with Art. 153(4) EPC

(43) Date of publication:
**23.10.2013 Bulletin 2013/43**

(51) Int Cl.:
***B32B 27/00*** *(2006.01)*          ***B32B 7/04*** *(2006.01)*
***H01L 31/042*** *(2006.01)*

(21) Application number: **11848546.5**

(22) Date of filing: **05.12.2011**

(86) International application number:
**PCT/JP2011/078074**

(87) International publication number:
**WO 2012/081437 (21.06.2012 Gazette 2012/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.12.2010 JP 2010278777**

(71) Applicant: **Nitto Denko Corporation
Osaka 567-8680 (JP)**

(72) Inventors:
• **NAKANISHI, Tadatoshi
Ibaraki-shi, Osaka 567-8680 (JP)**

• **ARIMITSU, Yukio
Ibaraki-shi, Osaka 567-8680 (JP)**
• **SHINTANI, Toshio
Ibaraki-shi, Osaka 567-8680 (JP)**
• **KAWABE, Shigeki
Ibaraki-shi, Osaka 567-8680 (JP)**
• **IKISHIMA, Shinsuke
Ibaraki-shi, Osaka 567-8680 (JP)**

(74) Representative: **Grünecker, Kinkeldey,
Stockmair & Schwanhäusser
Leopoldstrasse 4
80802 München (DE)**

(54) **LAMINATE**

(57)     Provided is a laminate including a thermoplastic resin layer and a substrate, which has superior transparency, is resistant to "warping", and is advantageous for the encapsulation and surface protection of opto-electronic devices.

The laminate includes a substrate; a thermoplastic resin layer having a thickness of more than 200 μm and less than or equal to 500 μm; and a pressure-sensitive adhesive layer lying between the substrate and thermoplastic resin layer and bonding them to each other, in which the thermoplastic resin layer has a 180-degree peel strength of 1.0 N/25 mm or more with respect to the pressure-sensitive adhesive layer at 23°C. The laminate preferably has a total luminous transmittance of 80% or more.

[Fig. 1]

EP 2 653 307 A1

**Description**

Technical Field

The present invention relates to laminates including a thermoplastic resin and a substrate laminated to each other through a pressure-sensitive adhesive layer. The laminates according to the present invention are advantageously used for the encapsulation and surface protection of opto-electronic devices.

Background Art

Solar cells, LEDs, and other opto-electronic devices each have a p-type semiconductor and an n-type semiconductor and utilize a photoelectric conversion activity in a depletion layer at a p-n junction. Specifically, solar cells can convert energy from sunlight directly to electrical energy; whereas LEDs can convert electrical energy to light energy.

The p-type and n-type semiconductors, if coming in direct contact with the outside atmosphere, deteriorate in their functions. To avoid this, the semiconductors are preferably encapsulated with a transparent encapsulant (molding compound) and further coated with a transparent protective film for impingement protection and for preventing contamination of foreign matter and intrusion typically of water. The protective film should have a sufficiently high volume resistivity from the viewpoint of required performance (intended use). For this purpose, laminates of a thermoplastic resin layer with an insulating film (e.g., a poly(ethylene terephthalate) (PET) film) have been used for the encapsulation and surface protection of opto-electronic devices.

Such laminates have been produced typically by a extrusion lamination process of heating and melting a thermoplastic resin; extruding the molten thermoplastic resin from a extrusion die into a film or sheet on a PET film or another insulating film; and bonding them to each other through thermocompression bonding. However, a laminate produced by this process, when cooled after the thermocompression bonding, suffers from "warping" due to cure shrinkage of the thermoplastic resin and, when used for the encapsulation and surface protection of opto-electronic devices, disadvantageously often causes encapsulation failure.

Patent Literature (PTL) 1 describes a process of heating and melting a thermoplastic resin; extruding the molten thermoplastic resin from a extrusion die into a film or sheet on a PET film or another insulating film while applying tension on the insulating film; and bonding them to each other through thermocompression bonding so as to prevent the occurrence of wrinkling on the laminate. Even this lamination process, however, failed to protect the laminate from "warping", although successively protecting it from wrinkling.

To produce a laminate by the extrusion lamination process, an anchor coating agent is generally applied to an interface between a thermoplastic resin layer and a PET film or another insulating film to improve anchoring capability between them, because such insulating film (e.g., PET film) and thermoplastic resin layer have poor anchoring capability with each other and often suffer from separation from each other. The anchor coating agent, however, causes whitening (or blushing) to cause the laminate to have a lower luminous transmittance. The resulting laminate, when used for the encapsulation and surface protection of opto-electronic devices, disadvantagously causes reduction in photoelectric conversion efficiency.

Citation List

Patent Literature

PTL 1: Japanese Unexamined Patent Application Publication (JP-A) No. 2000-85086

Summary of Invention

Technical Problem

Accordingly, an object of the present invention is to provide a laminate of a thermoplastic resin layer and a substrate, which has satisfactory transparency, is resistant to "warping", and is advantageously usable for the encapsulation and surface protection of opto- electronic devices.
Another object of the present invention is to provide an opto- electronic equipment including an opto- electronic device, in which the opto- electronic device is encapsulated with and surface- protected by the laminate.

Solution to Problem

After intensive investigations to achieve the objects, the present inventors have found a laminate including a thermoplastic resin layer and a substrate laminated to each other not through extrusion lamination but through the adhesiveness of a pressure-sensitive adhesive layer; and have found that the laminate is advantageously resistant to warping due to cure shrinkage of the thermoplastic resin, because there is no need of heating and melting the thermoplastic resin layer upon the formation of the laminate. The present inventors have further found that this laminate is also protected from deterioration in transparency due to whitening of an anchor coating agent, because the layers constituting the laminate can be firmly bonded to each other without the use of an anchor coating agent, unlike a laminate formed by extrusion lamination. The present invention has been made based on these findings.

Specifically, the present invention provides a laminate including a substrate; a thermoplastic resin layer having a thickness of more than 200 μm and less than or equal to 500 μm; and a pressure- sensitive adhesive layer lying between the substrate and the thermoplastic resin layer and bonding them to each other, in which the thermoplastic resin layer has a 180- degree peel strength of 1.0 N/ 25 mm or more with respect to the pressure- sensitive adhesive layer at 23°C.

The laminate preferably has a total luminous transmittance of 80% or more.

The pressure-sensitive adhesive layer is preferably an acrylic pressure-sensitive adhesive layer and more preferably an acrylic pressure-sensitive adhesive layer formed from an acrylic pressure-sensitive adhesive, the pressure-sensitive adhesive comprising, as an essential monomer component, a (meth)acrylic alkyl ester and/or a (meth)acrylic alkoxyalkyl ester each having at least one linear or branched-chain alkyl moiety. The pressure-sensitive adhesive layer preferably contains a crosslinking agent. The crosslinking agent is preferably a compound including no aromatic ring.

A thermoplastic resin constituting the thermoplastic resin layer is preferably a polyethylene or a copolymer of ethylene and a component other than α-olefins.

The substrate is preferably a plastic substrate or a glass substrate.

In addition and advantageously, the present invention provides an opto-electronic equipment including the opto-electronic device, in which the opto-electronic device is encapsulated with and surface-protected by the laminate.

Advantageous Effects of Invention

A laminate according to an embodiment of the present invention is resistant to "warping" (suffers from less or no warping) and much less causes encapsulation failure when used for the encapsulation and surface protection of opto-electronic devices. This is because the laminate includes a thermoplastic resin layer and a substrate laminated or bonded to each other not through extrusion lamination but through the adhesiveness of a pressure-sensitive adhesive layer. The laminate surely has high transparency, because the laminate does not require the use of an anchor coating agent or another whitening-causing compound which is used upon extrusion lamination. In addition, the laminate according to the present invention serves both as a surface-protecting film and an encapsulant, thereby exhibits more satisfactory workability and less causes reduction in transparency than the case where a surface-protecting film and an encapsulant are used separately. The laminate, even when covering an opto-electronic device, much less causes reduction in photoelectric conversion efficiency of the opto-electronic device. The laminate therefore enables, for example, the encapsulation and surface protection of a colar cell while much less causing reduction in efficiency of sunlight utilization and enables the encapsulation and surface protection of an LED while much less causing reduction in brightness (intensity) of the LED. Brief Description of Drawings

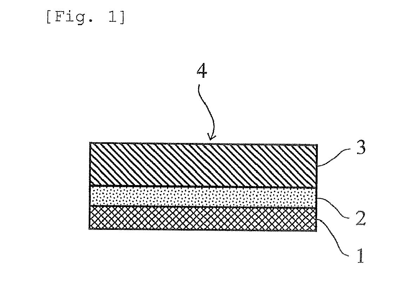

[Fig. 1] Fig. 1 is a schematic cross-sectional view illustrating a laminate according to an embodiment of the present invention.

Description of Embodiments

A laminate according to an embodiment of the present invention structurally includes a substrate, a thermoplastic resin layer having a thickness of more than 200 μm and less than or equal to 500 μm, and a pressure-sensitive adhesive layer lying between the substrate and the thermoplastic resin layer and bonding them to each other.

Fig. 1 is a schematic cross-sectional view illustrating a laminate according to an embodiment of the present invention. A laminate 4 includes a substrate 1; a pressure-sensitive adhesive layer 2 lying on the substrate 1; and a thermoplastic resin layer 3 lying on the pressure-sensitive adhesive layer 2.

[Pressure-sensitive Adhesive Layer]

Exemplary pressure- sensitive adhesives for constituting the pressure- sensitive adhesive layer for use in the present invention include known pressure- sensitive adhesives such as acrylic-, rubber-, vinyl alkyl ether-, silicone-, polyester-, polyamide-, urethane-, fluorine-, and epoxy- based pressure- sensitive adhesives. Each of different pressure-sensitive adhesives may be used alone or in combination. Such pressure- sensitive adhesives may be of any form such as emulsion pressure- sensitive adhesives, solvent- borne (solution) pressure- sensitive adhesives, and active- energy-ray- curable pressure- sensitive adhesives.

Among them, acrylic pressure-sensitive adhesives are preferred as the pressure-sensitive adhesive for constituting the pressure-sensitive adhesive layer. Specifically, the pressure-sensitive adhesive layer is preferably an acrylic pressure-sensitive adhesive layer. The acrylic pressure-sensitive adhesive layer is a pressure-sensitive adhesive layer containing, as a base polymer, an acrylic polymer formed from at least one acrylic monomer as an essential monomer component.

Of the acrylic polymers for constituting the acrylic pressure-sensitive adhesive layer, preferred are acrylic polymers each formed from, as an essential monomer component, a (meth)acrylic alkyl ester and/or (meth)acrylic alkoxyalkyl ester each having a linear or branched-chain alkyl moiety. These acrylic polymers each give a pressure-sensitive adhesive layer which is relatively flexible at room temperature, satisfactorily contributes to stress relaxation, and protects the laminate, when used for the encapsulation and surface protection of opto-electronic devices, from misregistration and encapsulation failure. Of such acrylic polymers, particularly preferred are acrylic polymers each formed from, as essential monomer components, a (meth)acrylic alkyl ester and an acrylic alkoxyalkyl ester each having a linear or branched-chain alkyl moiety. Specifically, the pressure-sensitive adhesive layer is particularly preferably an acrylic pressure-sensitive adhesive layer formed from, as essential monomer components, at least one (meth)acrylic alkyl ester and at least one acrylic alkoxyalkyl ester each having a linear or branched-chain alkyl moiety.

The pressure-sensitive adhesive layer, when including an acrylic alkoxyalkyl ester as an essential monomer component to constitute an acrylic polymer as a base polymer, not only contributes to stress relaxation but also prevents or suppress a gap and separation from an adherend even in hot and humid environments. This is probably because the alkoxyl moiety (alkoxy moiety) of the acrylic alkoxyalkyl ester helps the acrylic polymer to have suitable entanglement among molecular chains when the acrylic polymer is crosslinked so as to have a higher molecular weight; and the resulting pressure-sensitive adhesive layer can thereby exhibit a high adhesive strength and be resistant to reduction in storage elastic modulus even in hot and humid environments. Specifically, the pressure-sensitive adhesive layer, even when having a relatively low gel fraction and/or a relatively low storage elastic modulus (23°C), is resistant to excessive reduction in adhesive strength and storage elastic modulus even in hot and humid environments, can contribute to stress relaxation, and is resistant to blistering/separation.

Monomer components to form the acrylic polymer as a base polymer of the pressure-sensitive adhesive layer may further include one or more copolymerizable monomer components such as polar-group-containing monomers, multifunctional monomers, and other copolymerizable monomers.

As used herein the term "(meth)acrylic" refers to "acrylic" and/or "methacrylic"; and the same is true for other descriptions. Though not critical, the pressure-sensitive adhesive layer may contain the acrylic polymer as a base polymer in a content of preferably 60 percent by weight or more (e.g., 60 to 100 percent by weight) and more preferably 80 to 100 percent by weight, based on the total weight (100 percent by weight) of the pressure-sensitive adhesive layer.

Essential monomer components to form the acrylic polymer preferably include at least one (meth) acrylic alkyl ester having a linear or branched- chain alkyl moiety (hereinafter also simply referred to as "(meth) acrylic alkyl ester (s) "). The (meth) acrylic alkyl ester is exemplified by (meth) acrylic alkyl esters whose alkyl moiety having 1 to 20 carbon atoms, such as methyl (meth) acrylate, ethyl (meth) acrylate, propyl (meth) acrylate, isopropyl (meth) acrylate, butyl (meth) acrylate, isobutyl (meth) acrylate, s- butyl (meth) acrylate, t- butyl (meth) acrylate, pentyl (meth) acrylate, isopentyl (meth) acrylate, hexyl (meth) acrylate, heptyl (meth) acrylate, octyl (meth) acrylate, 2- ethylhexyl (meth) acrylate, isooctyl (meth) acrylate, nonyl (meth) acrylate, isononyl (meth) acrylate, decyl (meth) acrylate, isodecyl (meth) acrylate, undecyl (meth) acrylate, dodecyl (meth) acrylate, tridecyl (meth) acrylate, tetradecyl (meth) acrylate, pentadecyl (meth) acrylate, hexadecyl (meth) acrylate, heptadecyl (meth) acrylate, octadecyl (meth) acrylate, nonadecyl (meth) acrylate, and eicosyl (meth) acrylate. Each of different (meth) acrylic alkyl esters may be used alone or in combination. Of (meth) acrylic alkyl esters for use herein, (meth) acrylic alkyl esters whose alkyl moiety having 2 to 14 carbon atoms are preferred; (meth) acrylic alkyl esters whose alkyl moiety having 2 to 10 carbon atoms are more preferred; and 2- ethylhexyl acrylate (2EHA) is most preferred.

(Meth) acrylic alkoxyalkyl esters [alkoxyalkyl (meth) acrylates] are also advantageously usable as essential monomer components to form the acrylic polymers. Among them, acrylic alkoxyalkyl esters [alkoxyalkyl acrylates] are more preferred. Such (meth) acrylic alkoxyalkyl esters include, but not limited to, 2- methoxyethyl (meth) acrylate, 2- ethyoxyethyl (meth) acrylate, methoxytriethylene glycol (meth) acrylate, 3- methoxypropyl (meth) acrylate, 3- ethoxypropyl (meth) acrylate, 4- methoxybutyl (meth) acrylate, and 4- ethoxybutyl (meth) acrylate. Each of different (meth) acrylic alkoxyalkyl esters may be used alone or in combination. Among them, 2- methoxyethyl acrylate (2MEA) is preferably used herein.

Monomer components constituting the acrylic polymer may contain essential monomer component (s) [(meth) acrylic alkyl ester and/or (meth) acrylic alkoxyalkyl ester] in a content of preferably 5 percent by weight or more (e.g., 5 to 100 percent by weight) and more preferably 5 to 95 percent by weight, based on the total amount (100 percent by weight) of entire monomer components constituting the acrylic polymer. This range is preferred for satisfactory adhesiveness of the pressure- sensitive adhesive layer. When the monomer components employ both at least one (meth) acrylic alkyl ester and at least one (meth) acrylic alkoxyalkyl ester, the total sum (total content) of the content of the (meth) acrylic alkyl ester and the (meth) acrylic alkoxyalkyl ester may preferably fall within the above- specified range.

In a preferred embodiment, the monomer components constituting the acrylic polymer employ both at least one (meth)acrylic alkyl ester and at least one (meth)acrylic alkoxyalkyl ester as essential monomer components. In this embodiment, the (meth)acrylic alkyl ester may be contained in a content of preferably 5 to 95 percent by weight, more preferably 10 to 90 percent by weight, furthermore preferably 65 to 80 percent by weight, and most preferably 65 to 75 percent by weight, based on the total amount (100 percent by weight) of entire monomer components constituting the acrylic polymer. The (meth)acrylic alkyl ester, if contained in a content of more than 95 percent by weight, may cause the pressure-sensitive adhesive layer to have insufficient adhesiveness; and, if contained in a content of less than 5 percent by weight, may cause the pressure-sensitive adhesive layer to have an excessively high elastic modulus. The (meth)acrylic alkoxyalkyl ester may be  contained in a content of preferably 5 to 45 percent by weight, more preferably 10 to 40 percent by weight, furthermore preferably 20 to 35 percent by weight, and most preferably 20 to 34.5 percent by weight, based on the total amount (100 percent by weight) of entire monomer components constituting the acrylic polymer. The (meth)acrylic alkoxyalkyl ester, if contained in a content of more than 45 percent by weight, may cause the pressure-sensitive adhesive layer to have an excessively high elastic modulus; and, if contained in a content of less than 5 percent by weight, may cause the pressure-sensitive adhesive layer to have insufficient adhesiveness.

The polar- group- containing monomers are exemplified by carboxyl- containing monomers such as (meth) acrylic acid, itaconic acid, maleic acid, fumaric acid, crotonic acid, and isocrotonic acid, as well as anhydrides of them, such as maleic anhydride; hydroxyl- containing monomers including hydroxylalkyl (meth) acrylates such as 2- hydroxyethyl (meth) acrylate, 3- hydroxypropyl (meth) acrylate, 4- hydroxybutyl (meth) acrylate, and 6- hydroxyhexyl (meth) acrylate, as well as vinyl alcohol and allyl alcohol; amido- containing monomers such as (meth) acrylamide, N, N- dimethyl (meth) acrylamide, N- methylol (meth) acrylamide, N- methoxymethyl (meth) acrylamide, N- butoxymethyl (meth) acrylamide,  and N- hydroxyethylacrylamide; amino- containing monomers such as aminoethyl (meth) acrylate, dimethylaminoethyl (meth) acrylate, and t- butylaminoethyl (meth) acrylate; glycidyl- containing monomers such as glycidyl (meth) acrylate and methylglycidyl (meth) acrylate; cyano- containing monomers such as acrylonitrile and methacrylonitrile; heterocycle- containing vinyl monomers such as N- vinyl- 2- pyrrolidone, (meth) acryloylmorpholine, N- vinylpyridine, N- vinylpiperidone, N- vinylpyrimidine, N- vinylpiperazine, N- vinylpyrrole, N- vinylimidazole, and N- vinyloxazole; sulfo- containing monomers such as sodium vinylsulfonate; phosphate- containing monomers such as 2- hydroxyethylacryloyl phosphate; imido- containing monomers such as cyclohexylmaleimide and isopropylmaleimide; and isocyanate- containing monomers such as 2- methacryloyloxyethyl isocyanate. Each of different polar- group- containing monomers may be used alone or in combination. Of the polar- group- containing monomers, preferred are carboxyl- containing monomers and acid anhydrides of them, hydroxyl- containing monomers, amino- containing monomers, amido- containing monomers, and heterocycle- containing vinyl monomers; of which acrylic acid (AA), 4- hydroxybutyl acrylate (4HBA), N- vinyl- 2- pyrrolidone (NVP), and N- hydroxyethylacrylamide (HEAA) are more preferred.

The polar-group-containing monomer may be contained in a content of preferably 15 percent by weight or less (e.g., 0.01 to 15 percent by weight) and more preferably 1 to 15 percent by weight, based on the total amount (100 percent by weight) of entire monomer components constituting the acrylic polymer. The polar-group-containing monomer, if contained in a content of more than 15 percent by weight, may for example cause the pressure-sensitive adhesive layer to have excessively high cohesive force and an excessively high storage elastic modulus (23°C) to insufficiently contribute to stress relaxation. In contrast, the polar-group-containing monomer, if contained in a content of less than 0.01 percent by weight, may cause the pressure-sensitive adhesive layer to have insufficient adhesiveness.

Among such polar-group-containing monomers, a hydroxyl-containing monomer may be contained in a content of preferably 5 percent by weight or less (0 to 5 percent by weight), more preferably 0.01 to 5 percent by weight, furthermore preferably 0.1 to 5 percent by weight, and most preferably 0.5 to 5 percent by weight, based on the total amount (100 percent by weight) of entire monomer components constituting the acrylic polymer. The hydroxyl-containing monomer, if contained in a content of more than 5 percent by  weight, may cause the pressure-sensitive adhesive layer to have excessively high cohesive force and an excessively high storage elastic modulus (23°C) and to contribute insufficiently to stress relaxation. The hydroxyl-containing monomer, if contained in a content of less than 0.01 percent by weight, may cause the pressure-sensitive adhesive layer to have insufficient cohesion. One or more other polar-group-containing monomers than hydroxyl-containing monomers (particularly any of carboxyl-containing monomers, amido-containing monomers, amino-containing monomers, and heterocycle-containing vinyl monomers) may be contained in a content of preferably 15 percent by weight or less (0 to 15 percent by weight), more preferably 0.1 to 15 percent by weight, and furthermore preferably 1 to 10 percent by weight, based on the total amount (100 percent by weight) of entire monomer components constituting the acrylic polymer. The other polar-group-containing monomers, if contained in a content of more than 15 percent by weight, may cause the pressure-sensitive adhesive layer to have excessively high cohesive force and an excessively high storage elastic modulus (23°C) and to contribute insufficiently to stress relaxation. In contrast, the other polar-group-containing monomers, if contained in a content of less than 0.1 percent by weight, may cause the pressure-sensitive adhesive layer to have insufficient adhesiveness.

The multifunctional monomers are exemplified by hexanediol di (meth) acrylate, butanediol di (meth) acrylate, (poly) ethylene glycol di (meth) acrylate, (poly) propylene glycol di (meth) acrylate, neopentyl glycol di (meth) acrylate, pentaerythritol di (meth) acrylate, pentaerythritol tri (meth) acrylate, dipentaerythritol hexa (meth) acrylate, trimethylolpropane tri (meth) acrylate, tetramethylolmethane tri (meth) acrylate, allyl (meth) acrylate, vinyl (meth) acrylate, divinylbenzene, epoxy acrylates, polyester acrylates, and urethane acrylates. Each of different multifunctional monomers may be used alone or in combination. Of the multifunctional monomers, trimethylolpropane triacrylate (TMPTA) is preferred.

The multifunctional monomer may be contained in a content of 0.5 percent by weight or less (e.g., 0 to 0.5 percent by weight) and preferably 0 to 0.1 percent by weight, based on the total amount (100 percent by weight) of entire monomer components constituting the acrylic polymer. The multifunctional monomer, if contained in a content of more than 0.5 percent by weight, may cause the pressure-sensitive adhesive layer to contribute insufficiently to stress relaxation due typically to excessively high cohesive force thereof. A multifunctional monomer does not have to be used upon the use of a crosslinking agent. However, when no crosslinking agent is used, the multifunctional monomer may be contained in a content of preferably 0.001 to 0.5 percent by weight and more preferably 0.002 to 0.1 percent by weight.

Copolymerizable monomers (other copolymerizable monomers) other than the polar- group- containing monomers and multifunctional monomers are exemplified by (meth) acrylic esters other than the (meth) acrylic alkyl esters, the (meth) acrylic alkoxyalkyl esters, the polar- group- containing monomers, and the multifunctional monomers, including cyclopentyl (meth) acrylate, cyclohexyl (meth) acrylate, isobornyl (meth) acrylate, and other (meth) acrylic esters having an alicyclic hydrocarbon group, as well as phenyl (meth) acrylate and other (meth) acrylic esters having an aromatic hydrocarbon group; vinyl acetate, vinyl propionate, and other vinyl esters; styrene, vinyltoluenes, and other aromatic vinyl compounds; ethylene, butadiene, isoprene, isobutylene, and other olefins or dienes; vinyl alkyl ethers and other vinyl ethers; and vinyl chloride.

The acrylic polymer may be prepared by polymerizing the monomer components by a known or customary polymerization process. The polymerization process to form the acrylic polymer is exemplified by solution polymerization, emulsion polymerization, bulk polymerization, and polymerization by the application of an active energy ray (active-energy- ray polymerization). Among them, solution polymerization and active- energy- ray polymerization are preferred typically for satisfactory transparency, water resistance, and cost of the laminate.

Exemplary active energy rays to be applied upon the active-energy-ray polymerization (photopolymerization) include ionizing radiation such as alpha ray, beta ray, gamma ray, neutron beams, and beam of electrons; and ultraviolet rays. Among them, ultraviolet rays are preferred. The energy, time, and procedure of the active energy ray application (irradiation) are not limited, as long as capable of activating a photoinitiator to induce a reaction of monomer component.

The solution polymerization may employ one or more different regular solvents. The solvents are exemplified by organic solvents including esters such as ethyl acetate and n-butyl acetate; aromatic hydrocarbons such as toluene and benzene; aliphatic hydrocarbons such as n-hexane and n-heptane; alicyclic hydrocarbons such as cyclohexane and methylcyclohexane; and ketones such as methyl ethyl ketone and methyl isobutyl ketone. Each of different solvents may be used alone or in combination.

Preparation of the acrylic polymer may employ any of polymerization initiators such as thermal initiators and photoinitiators (photopolymerization initiators) according to the type of the polymerization reaction. Each of different polymerization initiators may be used alone or in combination.

The photoinitiators are exemplified by benzoin ether- based, acetophenone- based, $\alpha$- ketol- based, aromatic sulfonyl chloride- based, photoactive oxime- based, benzoin- based, benzil- based, benzophenone- based, ketal- based, and thioxanthone- based photoinitiators. Such photoinitiators may be used in an amount not critical, but preferably 0.01 to 0.2 part by weight and more preferably 0.05 to 0.15 part by weight per 100 parts by weight of the total amount of entire monomer components constituting the acrylic polymer.

The benzoin ether- based photoinitiators are exemplified by benzoin methyl ether, benzoin ethyl ether, benzoin propyl ether, benzoin isopropyl ether, benzoin isobutyl ether, 2, 2- dimethoxy- 1, 2- diphenylethan- 1- one, and anisole methyl ether. The acetophenone- based photoinitiators are exemplified by 2, 2- diethoxyacetophenone, 2, 2- dimethoxy-2- phenylacetophenone, 1- hydroxycyclohexyl phenyl ketone, 4- phenoxydichloroacetophenone, and 4- (t- butyl) dichloroacetophenone. The $\alpha$- ketol- based photoinitiators are exemplified by 2- methyl- 2- hydroxypropiophenone and 1- [4-(2- hydroxyethyl) phenyl]- 2- methylpropan- 1- one. The aromatic sulfonyl chloride- based photoinitiators are exemplified by 2- naphthalenesulfonyl chloride. The photoactive oxime- based photoinitiators are exemplified by 1- phenyl- 1, 1-propanedione- 2- (o- ethoxycarbonyl)- oxime. The benzoin- based photoinitiators are exemplified by benzoin. The benzil photoinitiators are exemplified by benzil. The benzophenone- based photoinitiators are exemplified by benzophenone, benzoylbenzoic acid, 3, 3'- dimethyl- 4- methoxybenzophenone, polyvinylbenzophenones, and $\alpha$- hydroxycyclohexyl phenyl ketone. The ketal- based photoinitiators include benzyl dimethyl ketal. The thioxanthone- based photoinitiators include thioxanthone, 2- chlorothioxanthone, 2- methylthioxanthone, 2, 4- dimethylthioxanthone, isopropylthioxanthones, 2, 4- diisopropylthioxanthone, and dodecylthioxanthones.

The thermal initiators are exemplified by azo polymerization initiators such as 2, 2'- azobisisobutyronitrile, 2,2'- azobis- 2- methylbutyronitrile, dimethyl 2, 2,'- azobis (2- methylpropionate), 4, 4'- azobis (4- cyanovaleric acid), azobisisovaleronitrile, 2, 2'- azobis (2- amidinopropane) dihydrochloride, 2, 2'- azobis [2- (5- methyl- 2- imidazolin- 2-yl) propane] dihydrochloride, 2, 2'- azobis (2- methylpropionamidine) disulfate, and 2, 2'- azobis (N, N'- dimethyleneisobutyramidine) dihydrochloride; peroxide polymerization initiators such as dibenzoyl peroxide and t- butyl permaleate; and redox polymerization initiators. Such thermal initiators may be used in an amount not critical, within a known or customary range.

The pressure-sensitive adhesive layer may further include a crosslinking agent. The crosslinking agent, when present, enables control of the gel fraction of the pressure-sensitive adhesive layer through crosslinking of the base polymer (e.g., the acrylic polymer) to form the pressure-sensitive adhesive layer. This may help the pressure-sensitive adhesive layer to be resistant to excessive reduction in adhesive strength and storage elastic modulus and to exhibit both satisfactory stress relaxation capability and good blistering/separation resistance even at elevated temperatures. The crosslinking agent is exemplified by isocyanate-based, epoxy-based, melamine-based, peroxide-based, urea-based, metal alkoxide-based, metal chelate-based, metal salt-based, carbodiimide-based, oxazoline-based, aziridine-based, and amine-based crosslinking agents. Among them, any of isocyanate-based crosslinking agents and epoxy-based crosslinking agents is preferably employed. Each of different crosslinking agents may be used alone or in combination.

The isocyanate-based crosslinking agents are exemplified by lower aliphatic polyisocyanates such as 1,2-ethylene diisocyanate, 1,4-butylene diisocyanate, and 1,6-hexamethylene diisocyanate; alicyclic polyisocyanates such as cyclopentylene diisocyanate, cyclohexylene diisocyanate, isophorone diisocyanate, hydrogenated tolylene diisocyanate, and hydrogenated xylene diisocyanate; and aromatic polyisocyanates such as 2,4-tolylene diisocyanate, 2,6-tolylene diisocyanate, 4,4'-diphenylmethane diisocyanate, and xylylene diisocyanate. The isocyanate-based crosslinking agents are further exemplified by an adduct of tolylene diisocyanate with trimethylolpropane [the trade name "CORONATE L" supplied by Nippon Polyurethane Industry Co., Ltd.] and an adduct of hexamethylene diisocyanate with trimethylolpropane [the trade name "CORONATE HL" supplied by Nippon Polyurethane Industry Co., Ltd.].

The epoxy- based crosslinking agents are exemplified by N, N, N', N'- tetraglycidyl- m- xylenediamine, diglycidylaniline, 1, 3- bis (N, N- diglycidylaminomethyl) cyclohexane, 1, 6- hexanediol diglycidyl ether, neopentyl glycol diglycidyl ether, ethylene glycol diglycidyl ether, propylene glycol diglycidyl ether, polyethylene glycol diglycidyl ethers, polypropylene glycol diglycidyl ethers, sorbitol polyglycidyl ethers, glycerol polyglycidyl ethers, pentaerythritol polyglycidyl ethers, polyglycerol polyglycidyl ethers, sorbitan polyglycidyl ethers, trimethylolpropane polyglycidyl ethers, diglycidyl adipate, o- diglycidyl phthalate, triglycidyl- tris (2- hydroxyethyl) isocyanurate, resorcinol diglycidyl ether, bisphenol- S diglycidyl ethers; as well as epoxy resins having two or more epoxy groups per molecule. Such epoxy- based crosslinking agents are also available as commercial products available typically under the trade name "TETRAD C" from MITSUBISHI GAS CHEMICAL COMPANY, INC.

In a preferred embodiment of the present invention, the crosslinking agent is a compound containing no aromatic ring for allowing the pressure- sensitive adhesive layer to maintain satisfactory transparency, because such aromatic ring may disadvantageously cause yellowing. The compound is exemplified by 1, 6- hexamethylene diisocyanate and 1, 3- bis (N, N- diglycidylaminomethyl) cyclohexane and is also available as commercial products typically under the trade name "TETRAD C" from MITSUBISHI GAS CHEMICAL COMPANY, INC.; the trade name "CORONATE HL" from Nippon Polyurethane Industry Co., Ltd.; and the trade name "DURANATE" from Asahi Kasei Chemicals Corporation.

The pressure-sensitive adhesive layer may employ the crosslinking agent in an amount not critical, but, in the case of an acrylic pressure-sensitive adhesive layer, preferably 0 to 1 part by weight and more preferably 0 to 0.8 part by weight per 100 parts by weight of the total amount of entire monomer components constituting the acrylic polymer.

The pressure-sensitive adhesive layer may optionally employ any of known additives within ranges not adversely affecting advantages of the present invention. Such additives are exemplified by cross-linking promoters, tackifiers (e.g., rosin derivative resins, polyterpene resins, petroleum resins, and oil-soluble phenolic resins), age inhibitors, fillers, ultraviolet absorbers, antioxidants, chain-transfer agents, plasticizers, softeners, surfactants, and antistatic agents. The formation of the pressure-sensitive adhesive layer may employ a solvent. The solvent is not limited in type, may be a regular solvent, and is exemplified by those listed as solvents for the solution polymerization.

The pressure-sensitive adhesive layer may be formed by a known or customary process for the formation of a pressure-sensitive adhesive layer. Such process may vary depending typically on the polymerization procedure to form the base polymer, is not limited, but is exemplified by processes (1), (2), and (3) as follows:

(1) a process of applying a composition to a substrate, thermoplastic resin layer, or suitable separator (e.g., release paper) and irradiating the applied composition with an active energy ray to form a pressure-sensitive adhesive layer, in which the composition includes a mixture (monomer mixture) of monomer components to constitute a base polymer (e.g., an acrylic polymer), or a partial polymer of the monomer mixture, and optional additives such as a photoinitiator and/or a crosslinking agent;

(2) a process of applying a composition (solution) to a substrate, thermoplastic resin layer, or suitable separator (e.g., release paper), and drying and/or curing the applied composition to form a pressure-sensitive adhesive layer, in which the composition includes a base polymer, a solvent, and optional additives such as a crosslinking agent; and (3) a process of further drying the pressure-sensitive adhesive layer formed in the process (1).

As used herein the term "monomer mixture" refers to a mixture consisting of monomer component(s) for the formation of a base polymer; and the term "partial polymer" refers to a composition corresponding to the monomer mixture, except that one or more of constitutional components of the monomer mixture are partially polymerized.

The coating (application) in the formation process of the pressure-sensitive adhesive layer may be any of known coating procedures and may employ a customary coater such as rotogravure roll coater, reverse roll coater, kiss-contact roll coater, dip roll coater, bar coater, knife coater, spray coater, comma coater, or direct coater.

The pressure-sensitive adhesive layer may have a thickness of typically, but not limitatively, about 5 to about 100 $\mu$m, preferably about 15 to about 50 $\mu$m, and particularly preferably 15 to 35 $\mu$m. The pressure-sensitive adhesive layer, if having a thickness of less than the above-specified range, may insufficiently contribute to stress relaxation and to suppression in encapsulation failure. In contrast, the pressure-sensitive adhesive layer, if having a thickness of more than the above-specified range, may tend to have insufficient transparency. The pressure-sensitive adhesive layer may have a single-layer structure or multilayer structure.

The pressure-sensitive adhesive layer obtained by the process may have, on its surface, a bond strength with respect to the thermoplastic resin layer as follows. Typically, the pressure-sensitive adhesive layer may have a 180-degree peel strength (peel bonding strength) with respect to an EVA film at 23°C (hereinafter also referred to as a "180-degree peel strength (to EVA film)") of 1.0 N/25 mm or more, typically preferably about 1.0 to about 50 N/25 mm, more preferably 5 N/25 mm or more (e.g., 5 to 50 N/25 mm), furthermore preferably 10 N/25 mm or more, and still more preferably 15 N/25 mm or more. The pressure-sensitive adhesive layer, if having a 180-degree peel strength (to EVA film) of less than 1.0 N/25 mm, may insufficiently contribute to suppression in encapsulation failure. The 180-degree peel strength (to EVA film) can be measured by a 180-degree peel test at 23°C and 50% relative humidity using an EVA film as an adherend. Specifically, the 180-degree peel strength (to EVA film) can be measured typically according to JIS Z 0237 by preparing "EVAFLEX EV550" (thickness: 400 $\mu$m; supplied by DUPONT-MITSUI POLYCHEMICALS CO., LTD) as an adherend (test panel); laminating a surface of the pressure-sensitive adhesive layer onto the adherend; and peeling the pressure-sensitive adhesive layer from the adherend at an angle of 180 degrees at a tensile speed of 300 mm/minute. The measurement may be performed while lining the other surface (adhesive face) of the pressure-sensitive adhesive layer opposite to the surface to be measured with a backing (PET film, "LUMIRROR S-10" supplied by Toray Industries Inc., thickness: 25 $\mu$m).

The pressure-sensitive adhesive layer may have, on its surface, a bond strength with respect to the substrate as follows. Typically, the pressure-sensitive adhesive layer may have a 180-degree peel strength with respect to a thin-film glass at 23°C (hereinafter also referred to as a "180-degree peel strength (to thin-film glass)") of preferably 1.0 N/25 mm or more (e.g., 1.0 to 10 N/25 mm) and more preferably 3.0 N/25 mm or more. The pressure-sensitive adhesive layer, if having a 180-degree peel strength (to thin-film glass) of less than 1.0 N/25 mm, may insufficiently contribute to suppression in encapsulation failure. The 180-degree peel strength (to thin-film glass) may be measured by the procedure as with the 180-degree peel strength (to EVA film), except for using a thin-film glass (the trade name "ULTRA FINE FRAT GLASS" supplied by Nippon Sheet Glass Co., Ltd.) as the adherend.

The pressure-sensitive adhesive layer preferably has high transparency. Specifically, when the pressure-sensitive adhesive layer is laminated between a substrate and a thermoplastic resin layer as follows to give a laminate [(substrate) / (pressure-sensitive adhesive layer) / (thermoplastic resin layer)], the laminate may have a total luminous transmittance of preferably 85% or more and more preferably 90% or more of the total luminous transmittance of the substrate alone, where each total luminous transmittance is measured in the visible light wavelength range according to JIS K 7361. The total luminous transmittance may be measured typically with a haze meter (the trade name "HM-150" supplied by Murakami Color Research Laboratory).

In a preferred embodiment, the pressure-sensitive adhesive layer has a transparency within the above-specified range; namely, the laminate according to the present invention has a transparency retension within the above-specified range, where the transparency retention is the ratio of the total luminous transmittance of the laminate to the total luminous transmittance of the substrate. The laminate according to this embodiment, when used typically for the encapsulation and surface protection of a solar cell, enables the encapsulation and surface protection of the solar cell while significantly suppressing reduction in efficiency of sunlight utilization. The laminate, when used for the encapsulation and surface protection of an LED, enables the encapsulation and surface protection of the LED while significantly suppressing reduction in brightness of the LED.

[Thermoplastic Resin Layer]

A thermoplastic resin for constituting the thermoplastic resin layer is exemplified by, but not limited to, polyolefin resins including polyethylenes (e.g., low-density polyethylenes, linear low-density polyethylenes, metallocene-catalyzed polyethylenes, medium- density polyethylenes, and high- density polyethylenes), polypropylenes, polybutenes [e.g., poly (1- butene) s], poly (4- methyl- 1- pentene) s, α- olefin copolymers [e.g., copolymers of ethylene and an α- olefin having 3 to 10 carbon atoms, and copolymers of propylene and an α- olefin having 4 to 10 carbon atoms], copolymers of ethylene and another component than α- olefins [e.g., ethylene- unsaturated carboxylic acid copolymers such as ethylene- acrylic acid copolymers (EAAs) and ethylene- methacrylic acid copolymers (EMAAs) ; ionomers; ethylene- (meth) acrylic ester copolymers such as ethylene- methyl acrylate copolymers (EMAs), ethylene- ethyl acrylate copolymers (EEAs), and ethylene- methyl methacrylate copolymers (EMMAs) ; ethylene- vinyl acetate copolymers (EVA) ; and ethylene- vinyl alcohol copolymers] . Each of different polyolefin resins may be used alone or in combination. At least one surface of the thermoplastic resin layer is preferably free from a surface release treatment.

As the thermoplastic resin for use in the present invention, preferred are polyethylenes and copolymers of ethylene and another component than α-olefins, of which low-density polyethylenes (LDPEs), ethylene-vinyl acetate copolymers (EVAs), ethylene-methyl acrylate copolymers (EMAs), and ethylene-methyl methacrylate copolymers (EMMAs) are more preferred. This is because these polymers have melting points of 180 degrees or lower and can give a highly transparent thermoplastic resin layer. The thermoplastic resin for use herein may also be any of commercial products available typically under the trade name "EVAFLEX EV550" from DUPONT-MITSUI POLYCHEMICALS CO., LTD; and the trade name "ACRYFT WH302" from Sumitomo Kasei Co., Ltd.

The thermoplastic resin layer can be easily prepared according to a known process while suitably selecting conditions typically of its polymerization reaction and subsequent purification and fractionation. The thermoplastic resin layer is preferably an unstretched or substantially unstretched layer and preferably has a draw ratio of 3% or less both in a transverse direction (TD) and in a machine direction (MD). A thermoplastic resin layer having a draw ratio of more than 3% in a transverse direction and/or in a machine direction, if used, may give a laminate which often suffers from encapsulation failure upon the encapsulation and surface protection of opto-electronic devices.

In a preferred embodiment of the present invention, the thermoplastic resin layer has transparency and has a total luminous transmittance of typically preferably 80% or more and more preferably 85% or more, as measured in the visible light wavelength range according to JIS K 7361. The total luminous transmittance can be measured typically with a haze meter (the trade name "HM-150" supplied by Murakami Color Research Laboratory).

The thermoplastic resin layer preferably has a sufficient thickness for the encapsulation of opto-electronic devices and may have a thickness of more than 200 μm and less than or equal to 500 μm, preferably 250 to 500 μm, and more preferably 300 to 500 μm.

[Substrate]

A substrate for use in the present invention preferably has transparency and may have a total luminous transmittance of typically preferably 80% or more, more preferably 85% or more, and particularly preferably 90% or more as measured in the visible light wavelength range according to JIS K 7361. The total luminous transmittance may be measured typically with a haze meter (the trade name "HM-150" supplied by Murakami Color Research Laboratory).

The substrate is preferably a plastic substrate or glass substrate. Exemplary materials for the plastic substrate include polyesters such as poly(ethylene terephthalate)s, poly(ethylene naphthalate)s, poly(butylene terephthalate)s, and poly(butylene naphthalate)s; polyolefins such as polyethylenes, polypropylenes, and ethylene-propylene copolymers; polymers of cycloolefins such as norbornene, cyclopentene, and cyclobutene; poly(vinyl alcohol)s; poly(vinylidene chloride)s; poly(vinyl chloride)s; vinyl chloride-vinyl acetate copolymers; poly(vinyl acetate)s; polyamides; polyimides; celluloses; fluorocarbon resins; polyethers; polyetheramides; poly(phenylene sulfide)s; acrylic resins; polystyrenic resins such as polystyrenes; polycarbonates; and polyethersulfones.

In a preferred embodiment of the present invention, the substrate has satisfactory resistance to moisture and weather. For this reason, preferred as the substrate are plastic substrates including polyester films (of which poly(ethylene terephthalate) (PET) films are preferred) and polycycloolefinic films (of which norbornenic films are preferred); and thin-film glass. Among them, polycycloolefinic films (particularly norbornenic films) advantageously have satisfactory dimensional stability and uniformity in phase difference, in addition to satisfactory resistance to moisture and weather.

Independently, films derived from acrylic resins are preferably used as the substrate, of which films derived from methyl methacrylate resins (PMMAs) are more preferred, because the resulting substrate has extremely satisfactory transparency to provide further higher light harvesting ability.

Where necessary, the substrate may have undergone a customary surface treatment so as to have better adhesion with the pressure-sensitive adhesive layer. The surface treatment is exemplified by chromate treatment, exposure to ozone, exposure to flame, exposure to a high-voltage electric shock, treatment with ionizing radiation, and other chemical or physical oxidation treatments.

While the thickness of the substrate may be suitably controlled according to a material thereof, the substrate may have a thickness of typically about 10 to about 350 μm. The substrate has a thickness of preferably about 20 to about 200 μm in the case of a plastic substrate; and preferably about 100 to about 350 μm in the case of a glass substrate. The substrate, if having a thickness of less than the above-specified range, may tend to have insufficient ability to protect the electric generating element; and in contrast, if having a thickness of more than the above-specified range, may have lower transparency.

The substrate for use herein may also be any of commercial products available typically under the trade name "ULTRA FINE FRAT GLASS" from Nippon Sheet Glass Co., Ltd.; the trade name "ZeonorFilm" from ZEON CORPORATION; and the trade name "LUMIRROR T60" from Toray Industries Inc.

[Laminate]

The laminate according to the present invention includes a substrate and a thermoplastic resin layer bonded or laminated to each other through a pressure-sensitive adhesive layer, in which the thermoplastic resin layer has a thickness of more than 200 $\mu$m and less than or equal to $500\mu$ m. The laminate may be prepared typically in the following manner. Initially, a coating composition is applied onto the substrate (or thermoplastic resin layer) to form a pressure-sensitive adhesive layer, in which the coating composition contains a pressure-sensitive adhesive for constituting the pressure-sensitive adhesive layer, and, where necessary, a crosslinking agent and other additives. Alternately, the coating composition is applied onto a suitable separator (e.g., release paper) to form a pressure-sensitive adhesive layer, and the formed pressure-sensitive adhesive layer is transferred onto the substrate (or thermoplastic resin layer). In addition, the thermoplastic resin layer (or substrate) is laminated on the formed or transferred pressure-sensitive adhesive layer, and the resulting article is pressed at a pressure (load) of about 1 to about 10 kg/cm$^2$ typically using a roller to give the laminate.

The laminate according to the present invention includes a substrate and a thermoplastic resin layer bonded or laminated to each other not through extrusion lamination but through the adhesiveness of a pressure-sensitive adhesive layer and thereby does not invite cure shrinkage of the thermoplastic resin layer upon the formation of the laminate. The laminate is thereby protected from "warping" caused by cure shrinkage of the thermoplastic resin layer.

The laminate according to the present invention preferably has transparency and may have a total luminous transmittance of preferably 80% or more, more preferably 85% or more, and particularly preferably 90% or more as measured in the visible light wavelength range according to JIS K 7361. The total luminous transmittance may be measured typically with a haze meter (the trade name "HM-150" supplied by Murakami Color Research Laboratory).

The laminate according to the present invention having the properties, when used for the encapsulation and surface protection of opto-electronic devices, is resistant to encapsulation failure and less causes reduction in photoelectric conversion efficiency, which reduction may be caused by coverage of the opto-electronic devices with the laminate. For example, when used for the encapsulation and surface protection of a solar cell, the laminate can contribute to impingement protection and prevent contamination of foreign matter and intrusion typically of water while extremely less causing reduction in efficiency of sunlight utilization. When used for the encapsulation and surface protection of an LED, the laminate can contribute to impingement protection of the LED and prevent contamination of foreign matter and intrusion typically of water while extremely less causing reduction in brightness of the LED.

[Opto-electronic Equipment]

An opto-electronic equipment according to an embodiment of the present invention includes an opto-electronic device, in which the opto-electronic device is encapsulated with and surface-protected by the laminate. Exemplary opto-electronic devices for use herein include elements that convert electrical energy to light; and elements that convert light to electrical energy. Such opto-electronic device is exemplified by light-emitting diodes (LEDs) and solar cells. The laminate has satisfactory transparency and much less causes reduction in photoelectric conversion efficiency even when used for the encapsulation and surface protection. As suffering from little or no "warping", the laminate enables easy encapsulation and surface protection operation and less causes encapsulation failure. In addition, the laminate is highly resistant to weather and moisture and thereby protect the opto-electronic device from deterioration. The opto-electronic equipment according to the present invention includes an opto-electronic device encapsulated with and surface-protected by the laminate, can thereby exhibit a satisfactory photoelectric conversion efficiency, contributes to energy saving, is highly resistant to weather and moisture, and surely has a long life.

EXAMPLES

The present invention will be illustrated in further detail with reference to several exmaples below, which are by no means intended to limit the scope of the invention.

PREPARATION EXAMPLE 1 (Preparation of Pressure-sensitive Adhesive Layer (1))

Initially, a mixture was prepared by blending 69 parts by weight of 2- ethylhexyl acrylate (2EHA), 30 parts by weight of 2- methoxyethyl acrylate (2MEA), 1 part by weight of 4- hydroxybutyl acrylate (4HBA), and 1 part by weight of acrylic acid (AA) . The mixture was combined with photoinitiators, i.e., 0.05 part by weight of the trade name "IRGACURE 184" supplied by Ciba Specialty Chemicals Corporation and 0.05 part by weight of the trade name "IRGACURE 651" supplied by Ciba Specialty Chemicals Corporation, irradiated with an ultraviolet ray so as to have a viscosity of about 20 Pa.s as measured with a BH viscometer using a No. 5 rotor at 10 rpm and at a measurement temperature of 30°C, and thereby yielded a prepolymer composition in which part of the monomer components was polymerized.

The prepolymer composition (100 parts by weight) was combined with 0.01 part by weight of 1, 3- bis (N, N- diglycidylaminomethyl) cyclohexane [the trade name "TETRAD C" supplied by MITSUBISHI GAS CHEMICAL COMPANY, INC.] and yielded a composition for the formation of a pressure- sensitive adhesive layer.

The composition for the formation of a pressure- sensitive adhesive layer was applied onto a PET separator (the trade name "MRF75" supplied by Mitsubishi Plastics, Inc.) to form a pressure- sensitive adhesive layer having a final thickness (thickness of the pressure- sensitive adhesive layer) of 25 $\mu$m.

Next, a PET separator (the trade name "MRF38" supplied by Mitsubishi Plastics, Inc.) was arranged on the pressure-sensitive adhesive layer to cover the pressure- sensitive adhesive layer for the interception of oxygen.

The resulting sheet [laminate of (MRF75) / (coated layer) / (MRF38)] was irradiated with an ultraviolet ray at an illuminance of 5 mW/cm$^2$ for 300 seconds from the top side of the sheet (from the MRF38 side) using a blacklight (supplied by TOSHIBA CORPORATION) . The sheet was further subjected to a heat treatment in a heat oven at 120°C for 2 minutes to volatilize residual monomers to thereby form a pressure- sensitive adhesive layer. The resulting article was further heated and aged at 50°C for one week and yielded a pressure- sensitive adhesive layer (1) having a thickness of 25 $\mu$m (with a separator) .

PREPARATION EXAMPLE 2 (Preparation of Pressure-sensitive Adhesive Layer (2))

A pressure- sensitive adhesive layer (2) (with a separator) was prepared by the procedure of Preparation Example 1, except for using 1, 6- hexamethylene diisocyanate [the trade name "DURANATE" supplied by Asahi Kasei Chemicals Corporation] instead of 1, 3- bis (N, N- diglycidylaminomethyl) cyclohexane [the trade name "TETRAD C" supplied by MITSUBISHI GAS CHEMICAL COMPANY, INC.] .

PREPARATION EXAMPLE 3 (Preparation of Thermoplastic Resin Layer (1))

An EVA [the trade name "EVAFLEX EV550" supplied by DUPONT-MITSUI POLYCHEMICALS CO., LTD, melting point: 89°C] was heated and melted at a temperature of 180°C, extruded and molded through a T die and dried to form a thermoplastic resin layer (1) having a final thickness (thickness of the pressure-sensitive adhesive layer) of 400 $\mu$m. This had a total luminous transmittance of 90%.

PREPARATION EXAMPLE 4 (Preparation of Thermoplastic Resin Layer (2))

A thermoplastic resin layer (2) having a total luminous transmittance of 89% was formed by the procedure of Preparation Example 3, except for using an EMMA [the trade name "ACRYFT WH302" supplied by Sumitomo Kasei Co., Ltd., melting point: 94°C] instead of the EVA [the trade name "EVAFLEX EV550" supplied by DUPONT-MITSUI POLYCHEMICALS CO., LTD, melting point: 89°C].

EXAMPLE 1

The pressure-sensitive adhesive layer (1) prepared in Preparation Example 1, from which the separator had been removed, was laminated on a PET film [the trade name "LUMIRROR T60" supplied by Toray Industries Inc., thickness: 50 $\mu$m, total luminous transmittance: 89%] as a substrate, on which the thermoplastic resin layer (1) prepared in Preparation Example 3 was further laminated. The resulting article was pressed at a pressure of 2.0 kg/cm$^2$ and thereby yielded a laminate (1).

EXAMPLE 2

A laminate (2) was prepared by the procedure of Example 1, except for using the pressure-sensitive adhesive layer (2) prepared in Preparation Example 2 instead of the pressure-sensitive adhesive layer (1) prepared in Preparation Example 1; and using the thermoplastic resin layer (2) prepared in Preparation Example 4 instead of the thermoplastic resin layer (1) prepared in Preparation Example 3.

EXAMPLE 3

A laminate (3) was prepared by the procedure of Example 1, except for using a thin-film glass [the trade name "ULTRA FINE FRAT GLASS" supplied by Nippon Sheet Glass Co., Ltd., total luminous transmittance: 90%] instead of the PET film [the trade name "LUMIRROR T60" supplied by Toray Industries Inc., thickness: 50 $\mu$m, total luminous transmittance: 89%].

EXAMPLE 4

A laminate (4) was prepared by the procedure of Example 2, except for using a thin-film glass [the trade name "ULTRA FINE FRAT GLASS" supplied by Nippon Sheet Glass Co., Ltd., total luminous transmittance: 90%] instead of the PET film [the trade name "LUMIRROR T60" supplied by Toray Industries Inc., thickness: 50 $\mu$m, total luminous transmittance: 89%].

EXAMPLE 5

A laminate (5) was prepared by the procedure of Example 1, except for using a norbornenic film [the trade name "ZeonorFilm" supplied by ZEON CORPORATION, total luminous transmittance: 93%] instead of the PET film [the trade name "LUMIRROR T60" supplied by Toray Industries Inc., thickness: 50 $\mu$m, total luminous transmittance: 89%].

EXAMPLE 6

A laminate (6) was prepared by the procedure of Example 2, except for using a norbornenic film [the trade name "ZeonorFilm" supplied by ZEON CORPORATION, total luminous transmittance: 93%] instead of the PET film [the trade name "LUMIRROR T60" supplied by Toray Industries Inc., thickness: 50 $\mu$m, total luminous transmittance: 89%].

COMPARATIVE EXAMPLE 1

An anchor coating (AC) agent [the trade name "AD-527" supplied by Toyo-Morton, Ltd.] was applied to a final thickness of 0.02 $\mu$m onto a substrate PET film [the trade name "LUMIRROR T60" supplied by Toray Industries Inc., thickness: 50 $\mu$m, total luminous transmittance: 89%]. An LDPE [the trade name "SUMIKATHENE CE4003" supplied by Sumitomo Kasei Co., Ltd.] was heated and melted at a temperature of 300°C and extruded through a T die and laminated onto the anchor coating. In addition, an EVA [the trade name "EVAFLEX EV550" supplied by DUPONT-MITSUI POLYCHEMICALS CO., LTD] was heated and melted at a temperature of 180°C and extruded through a T die and laminated onto the LDPE layer and thereby yielded a laminate (7) [PET (thickness: 50 $\mu$m)/AC (thickness: 0.02 $\mu$m) /LDPE (thickness: 50 $\mu$m)/EVA (thickness: 350 $\mu$m)].

COMPARATIVE EXAMPLE 2

A laminate (8) [PET (thickness: 50 $\mu$m)/AC (thickness: 0.02 $\mu$m)/LDPE (thickness: 50 $\mu$m)/EMMA (thickness: 350 $\mu$m)] was prepared by the procedure of Comparative Example 1, except for using an EMMA [the trade name "ACRYFT WH302" supplied by Sumitomo Kasei Co., Ltd.] instead of the EVA [the trade name "EVAFLEX EV550" supplied by DUPONT-MITSUI

POLYCHEMICALS CO., LTD].

The laminates prepared in the examples and comparative examples were examined by the following methods to evaluate their "warping" resistance and transparency change.

["Warping" Resistance]

Each of the laminates prepared in the examples and comparative examples was cut to a size of 50 mm wide by 100 mm long to give a specimen.
The prepared specimen was placed and left stand on a glass sheet at an ambient temperature of 25°C and relative humidity of 55%, gap distances from the glass sheet were measured at a lengthwise end face and a widthwise end face with vernier calipers, and a maximum of the gap distances was defined as a "warping" (mm). A smaller "warping" means more satisfactory "warping" resistance.

[Total Luminous Transmittance and Transparency Retension]

The total luminous transmittance ($L_a$ (%)) of each of the laminates prepared in the examples and comparative examples was measured with a haze meter (the trade name "HM-150" supplied by Murakami Color Research Laboratory) according to JIS K 7361.

Independently, the total luminous transmittance ($L_b$ (%)) of the substrate alone constituting the laminate was measured by the same procedure.

A transparency retension was calculated according to an equation as follows:

$$\text{Transparency Retension (\%)} = (La/Lb) \times 100$$

The results are collectively indicated in a table below.

[Table 1]

TABLE 1

| | | Example 1 | Example 2 | Example 3 | Example 4 | Example 5 | Example 6 | Comparative Example 1 | Comparative Example 2 |
|---|---|---|---|---|---|---|---|---|---|
| Warping (mm) | Widthwise | 0 | 0 | 0 | 0 | 0 | 0 | 18 | 21 |
| | Lengthwise | 0 | 0 | 0 | 0 | 0 | 0 | 9 | 8 |
| Total luminous transmittance (%) | $L_a$ | 89 | 89 | 90 | 90 | 93 | 93 | 68 | 71 |
| | $L_b$ | 89 | 89 | 90 | 90 | 93 | 93 | 89 | 89 |
| Transparency retention (%) | | 100 | 100 | 100 | 100 | 100 | 100 | 76.4 | 79.8 |

Industrial Applicability

Laminates according to embodiments of the present invention suffer from less or no "warping" and, when used for the encapsulation and surface protection of an opto-electronic device, can significantly less cause encapsulation failure and can retain high transparency. The laminates serve both as a surface-protecting film and an encapsulant, thereby exhibit more satisfactory workability, less cause reduction in transparency, and extremely less cause reduction in photoelectric conversion efficiency due to covering of the opto-electronic device, than the case employing both a surface-protecting film and an encapsulant separately. The laminates therefore enable the encapsulation and surface protection typically of a solar cell while much less causing reduction in efficiency of sunlight utilization; and enable the encapsulation and surface protection of an LED while much less causing reduction in brightness.

Reference Signs List

1    substrate
2    pressure-sensitive adhesive layer
3    thermoplastic resin layer
4    laminate

**Claims**

1.   A laminate comprising: a substrate; a thermoplastic resin layer having a thickness of more than 200 $\mu$m and less than or equal to 500 $\mu$m; and a pressure-sensitive adhesive layer lying between the substrate and the thermoplastic resin layer and bonding them to each other, wherein the thermoplastic resin layer has a 180-degree peel strength of 1.0 N/25 mm or more with respect to the pressure-sensitive adhesive layer at 23°C.

2.   The laminate of claim 1, wherein the laminate has a total luminous transmittance of 80% or more.

3.   The laminate of one of claims 1 and 2, wherein the pressure-sensitive adhesive layer is an acrylic pressure-sensitive adhesive layer.

4.   The laminate of any one of claims 1 to 3, wherein the pressure-sensitive adhesive layer is an acrylic pressure-sensitive adhesive layer formed from an acrylic pressure-sensitive adhesive, the pressure-sensitive adhesive comprising, as an essential monomer component, a (meth)acrylic alkyl ester and/or a (meth)acrylic alkoxyalkyl ester each having at least one linear or branched-chain  alkyl moiety.

5.   The laminate of any one of claims 1 to 4, wherein the pressure-sensitive adhesive layer comprises a crosslinking agent.

6.   The laminate of claim 5, wherein the crosslinking agent is a compound including no aromatic ring.

7.   The laminate of any one of claims 1 to 6, wherein the thermoplastic resin layer is formed from a thermoplastic resin which is a polyethylene or a copolymer of ethylene and a component other than $\alpha$-olefins.

8.   The laminate of any one of claims 1 to 7, wherein the substrate is a plastic substrate or a glass substrate.

9.   An opto-electronic equipment comprising an opto-electronic device, wherein the opto-electronic device is encapsulated with and surface-protected by the laminate of any one of claims 1 to 8.

[Fig. 1]

## INTERNATIONAL SEARCH REPORT

| | International application No. |
|---|---|
| | PCT/JP2011/078074 |

A. CLASSIFICATION OF SUBJECT MATTER
*B32B27/00*(2006.01)i, *B32B7/04*(2006.01)i, *H01L31/042*(2006.01)i

According to International Patent Classification (IPC) or to both national classification and IPC

B. FIELDS SEARCHED

Minimum documentation searched (classification system followed by classification symbols)
B32B1/00-43/00, H01L31/042

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2010-212357 A  (Toppan Printing Co., Ltd.),<br>24 September 2010 (24.09.2010),<br>claims; paragraphs [0016], [0018], [0028],<br>[0036], [0037]<br>(Family: none) | 1,2,7-9<br>1-9 |
| Y | JP 2010-238790 A  (Lintec Corp.),<br>21 October 2010 (21.10.2010),<br>claims; paragraphs [0007], [0014] to [0026],<br>[0030] to [0034]<br>(Family: none) | 1-9 |
| Y | JP 2006-269608 A  (Canon Inc.),<br>05 October 2006 (05.10.2006),<br>paragraph [0043]<br>(Family: none) | 1-9 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>17 February, 2012 (17.02.12) | Date of mailing of the international search report<br>28 February, 2012 (28.02.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2011/078074 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 08-139350 A (Canon Inc.),<br>31 May 1996 (31.05.1996),<br>paragraph [0066]<br>& US 5660646 A | 1-9 |
| Y | JP 2010-186933 A (Tosoh Corp.),<br>26 August 2010 (26.08.2010),<br>paragraphs [0064], [0065]<br>(Family: none) | 1-9 |
| Y | JP 2005-129713 A (Sharp Corp.),<br>19 May 2005 (19.05.2005),<br>paragraph [0018]<br>(Family: none) | 1-9 |
| Y | JP 2006-339684 A (Fuji Electric Holdings Co.,<br>Ltd.),<br>14 December 2006 (14.12.2006),<br>paragraphs [0015], [0016]<br>(Family: none) | 2 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2000085086 A